(19) Europäisches Patentamt
European Patent Office
Office européen des brevets

(11) **EP 3 865 860 B1**

(12) **EUROPEAN PATENT SPECIFICATION**

(45) Date of publication and mention
of the grant of the patent:
**18.09.2024 Bulletin 2024/38**

(21) Application number: **20020071.5**

(22) Date of filing: **14.02.2020**

(51) International Patent Classification (IPC):
**G01N 21/64** (2006.01)     **G02B 6/122** (2006.01)
**G02B 1/118** (2015.01)     **G02B 1/00** (2006.01)

(52) Cooperative Patent Classification (CPC):
**G02B 6/1226; G02B 6/0003; G02B 6/0076;
H10K 50/856**

(54) **DEVICE FOR ULTRA-BRIGHT DIRECTIONAL LIGHT EMISSION**

VORRICHTUNG ZUR ULTRAHELLEN GERICHTETEN LICHTEMISSION

DISPOSITIF D'ÉMISSION DE LUMIÈRE DIRECTIONNELLE ULTRA-BRILLANTE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.08.2021 Bulletin 2021/33**

(73) Proprietors:
• **Elmitwalli (Galal), Hossam**
**50825 Köln (DE)**
• **Samir, Ahmed**
**El Nozha, Cairo 11361 (EG)**

(72) Inventor: **Elmitwalli (Galal), Hossam**
**50825 Köln (DE)**

(74) Representative: **Prüfer & Partner mbB
Patentanwälte · Rechtsanwälte
Sohnckestraße 12
81479 München (DE)**

(56) References cited:
WO-A2-2009/007919     WO-A2-2018/096097
US-A1- 2005 104 075     US-A1- 2005 194 896
US-A1- 2011 080 738     US-A1- 2016 079 566
US-A1- 2017 005 141

• JONATHAN HU ET AL: "Understanding leaky
modes: slab waveguide revisited", ADVANCES IN
OPTICS AND PHOTONICS, vol. 1, no. 1, 29
January 2009 (2009-01-29), pages 58,
XP055443489, DOI: 10.1364/AOP.1.000058

## Description

### Technical problem background

Light extraction and directional emission, especially from large-refractive index materials, is a bottleneck for many light emission applications such as Light Emitting Diodes (LED), Lasers, and Single Photon Sources (SPS). A significant amount of light is lost inside the structure of the light emitting device, whether due to Total Internal Reflection (TIR) or due to the presence of metallic elements.

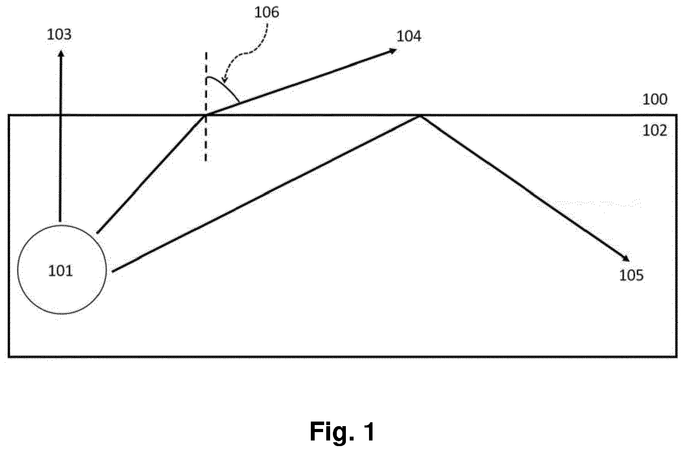

Consider the scenario depicted in Fig. 1, where a light source (101) is embedded in an active medium (102) having a refractive index larger than 1. The designation "active medium" defines the medium that hosts the light source. The collection medium (100) is free-space with a refractive index equal to 1. For the sake of simplicity, consider that the light source (101) emits the three light rays: (103), (104), and (105). Apparently, the rays undergo different behaviors in response to their different projections. The light ray (103) experiences no modulation, since it is incident normal to the interface between the mediums (102)-(100). The light ray (104) is refracted, and diverges with an angle (106). The light ray (105) is incident at the interface between the mediums (102)-(100) with an angle larger than the critical angle, and undergoes TIR. The light ray (105) is trapped inside the active medium (102), and accordingly, the brightness (i.e. the efficiency) of the light source (101), observed from the collection medium (100), is reduced. The light ray (104) fans out away from the path of the light ray (103), and gives rise to an emission beam with a large divergence angle (i.e. poor collimation). Typically, large numerical aperture optics would be required to handle such beam profile.

The light extraction efficiency can be defined as: the amount of light that is radiated into the collection medium, divided by the total amount of light that is emitted by the light source within the active medium.

In the example of Fig. 1, this translates into:

$$Light\ extraction\ efficiceny\ = \frac{ray(103) + ray(104)}{ray(103) + ray(104) + ray(105)}$$

In the relationship above, and by considering the case where the collection medium (100) is free-space, the light extraction efficiency is further defined as the "free-space light extraction". This definition is more specific, and will be recalled often throughout the context of this text since the focus of this patent application is more on free-space emission applications.

With the simple illustration of Fig. 1 in mind, the problem becomes more challenging when the refractive index discrepancy between the active medium (102) and the collection medium (100) becomes large. According to Snell's law; ray divergence and TIR light trapping are proportional to the refractive index of the active medium (102). High-refractive index materials, such as diamond and semiconductors, are in the heart of many classical-light and quantum-light emitting devices. Thinking of LEDs, lasers, and SPSs; many photonic applications require that the light is emitted into free-space with very high brightness and within a very narrow numerical aperture cone.

There have been numerous efforts to enhance the light extraction efficiency of light sources. The trend has been to incorporate nano-structures, taking advantage of the latest advances in nanotechnology.

However; to date, the reported results are not yet to full satisfaction, and the proposed solutions are quite sophisticated and just make the whole process more complex and costly. Furthermore, the light radiation pattern is unavoidably compromised (i.e. does not have a uniform pattern and develops very broad radiation angles and side-lobes).

A practical solution to this longstanding optical problem would be one that fulfills the following criteria:

1. A near 100% free-space light extraction efficiency.
2. The radiated light should be highly collimated, directional, and single-lobed.
3. The light emitting device structure should be simple and free of any complex architectures, with large tolerance margins to accommodate technological imperfections.
4. The proposed solution should be scalable and applicable to different materials and wavelengths.

These four requirements, as a whole, are very challenging and have never been met before. However; there have been some interesting trials, where some of the four requirements were partially fulfilled. In the next section, the relevant prior art in this regard is reviewed.

### Prior art review

US 2011/0080738 A1 discloses a light-emitting device having a transparent substrate adjacent to a light-emitting body. The light-emitting substrate has a surface structure defined by dividing the surface into a plurality of linear segments of width w which are inclined so as to extend in a specific direction in a plane of the surface. Such linear segments are divided into minute regions, each of which is formed by a raised or recessed portion formed in the surface of the transparent substrate. Thereby, the light extraction efficiency can be greatly improved in that extraction of light rays whose incidence angles are greater than the critical angle can be repeatedly realized.

US 2016/0079566 A1 describes a surface light emitting element including a light emitting layer that emits light, a first electrode layer that is provided on the side of the light emitting layer from which the light is extracted and allows the light that has been emitted by the light emitting layer to pass through, a second electrode layer that is provided on the side of the light emitting layer from which light is not extracted, a light scattering layer that is provided on the side of the first electrode layer opposite to the side on which the light emitting layer is positioned, and a transparent substrate that is provided on the side of the light scattering layer opposite to the side on which the light emitting layer is positioned. In particular, a conductive material in which the real part of a complex dielectric constant is negative is used in the first electrode layer.

**Prior art: WO2016166130**

The journal publication [1] covers in details the scientific background for this pending patent application.
Fig. 2a: It has been suggested in WO2016166130 and in [1] that a Hertzian horizontal dipole emitter (201), hosted in an active medium (202), when placed in close proximity to a highly reflective metal layer (203), an image (204) of the dipole is induced in the metal layer (203).

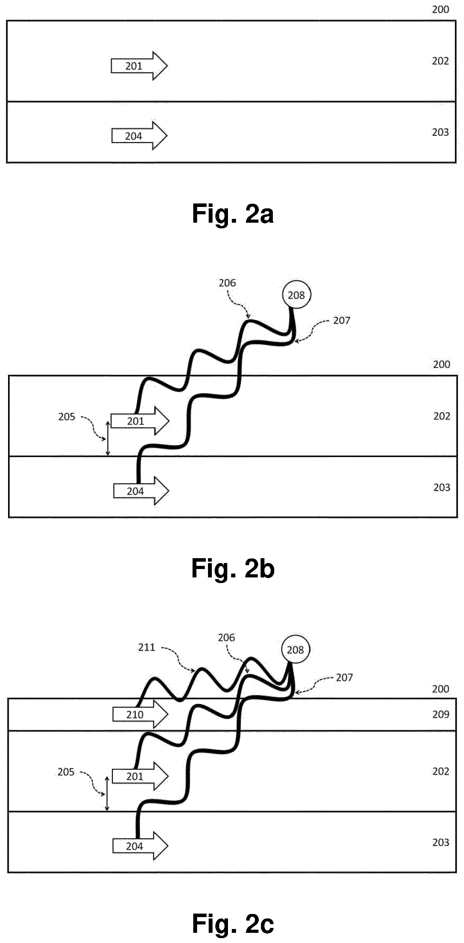

Fig. 2b: When the distance d (205) from the dipole emitter (201) to the interface between the layers (202)-(203) is within the limit:

$$\lambda/(6n) < d < \lambda/(4n)$$

*[Where $\lambda$ is the wavelength of the light emitted by the dipole emitter (201), and n is the refractive index of the active medium (202)]*
Both the dipole emitter (201) and its image (204) radiate in phase; and their corresponding electromagnetic radiations, (206) and (207) respectively, give rise to constructive interference in the far-field spot (208) located in the collection medium (200). This concept has been referred to as dipole-image interference.
Fig. 2c: By further placing a semi-transparent metal layer (209) between the collection medium (200) and the active medium (202), a second image (210) of the dipole emitter (201) is induced in the semi-transparent metal layer (209). By adjusting the thickness of the active medium (202), the electromagnetic radiation (211) from the second dipole image (210) can be constructively interfered with the electromagnetic radiations (206) and (207). As a result, the radiation pattern, observed from the collection medium (200), develops narrower radiation angles. The configuration with the reflector (203), the active medium (202), and the semi-transparent metal (209) has been conceived by the corresponding inventors-authors as a planar antenna.
This prior art has severe drawbacks:

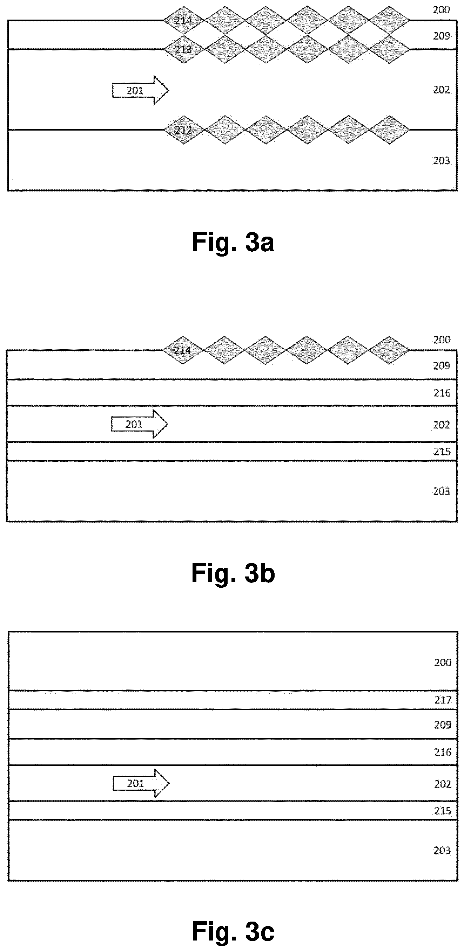

1. The light extraction efficiency is highly limited by Surface Plasmon Polariton (SPP) losses at the interfaces between the layers: (202)-(203), (202)-(209), and (209)-(200) [See illustrations (212), (213), and (214) in Fig. 3a.].
2. This approach is not applicable to high-refractive index materials, for example diamond and semiconductors. The reason being, SPP losses are directly proportional to the refractive index of the active medium (202).

These drawbacks have been conditionally resolved in the successive prior art WO002018096097.

**Prior art: WO002018096097**

The journal publication [2] covers in details the theoretical background for this pending patent application. The related experimental results are partially available in the journal preprint [3].
This prior art also applies the dipole-image interference concept, or the so-called planar antenna, similar to the previous prior art WO2016166130. However, an improvement is introduced, where the SPP losses are considerably reduced; giving rise to a much higher light extraction efficiency as compared to WO2016166130. Accordingly, the approach can, cautiously, be applied to high-refractive index materials such as diamond and semiconductors.
Fig. 3a: This depiction is an elaboration of the recent argument started in Fig. 2c. At the interface between layers (202)-(203), an SPP loss mode (212) exists. In this context, an SPP is a collective electron oscillation behavior that gives rise to a guided mode(s) along metal-dielectric interfaces. For demystification, an SPP mode is represented in Fig. 3 with a train of shaded diamond shapes. At the interface between layers (202)-(209), a second SPP loss mode (213) exists. At the interface between layers (209)-(200), a third SPP loss mode (214) exists. The SPP loss modes (212), (213), and (214) are larger when the refractive index of the active medium (202) is high.

Fig. 3b: By introducing the intermediate layers (215) and (216) as shown, where the refractive indices of these layers have to be lower than the refractive index of the active medium (202), the SPP loss modes (212) and (213) can be reduced.

Fig. 3c: By further introducing the intermediate layer (217) as shown, where the refractive index of this layer has to be smaller than the refractive index of the collection medium (200), the SPP loss mode (214) can be reduced, provided that, the refractive index of the intermediate layer (217) is on the order of 1. This configuration does not work for free-space emission, since the refractive index of the collection medium (200) has to be much larger than the refractive index of the intermediate layer (217). Note that, in Fig. 3c the collection medium (200) is represented in a different way, with closed boundaries, as an indication that it can no longer be free-space.

This prior art has some limitations:

1. Since this approach relies on the suppression of SPP losses, the refractive indices of the intermediate layers (215), (216), and (217) have to be very low and chosen in correlation with the refractive indices of the active medium (202) and the collection medium (200). This restriction limits the material choice options and the applicability of the scheme to some operational wavelengths.

2. Even with the reduction of the SPP loss modes (212) and (213), the free-space light extraction efficiency saturates close to 80% [2].

3. With the further reduction of the SPP loss mode (214), in the configuration of Fig. 3c, the light extraction efficiency (this is different from the free-space light extraction efficiency) can reach 90%. However; as mentioned earlier, the configuration in Fig. 3c does not work for free-space emission, since the refractive index of the collection medium (200) has to be very high with respect to the refractive index of the intermediate layer (217).

## Prior art summary

The trend in the two discussed patent pending applications WO2016166130 and WO002018096097, and their corresponding journal publications; has been imaging a dipole emitter in metallic layers, and interfering the dipole with its induced images constructively. The prior art WO002018096097 extended the applicability of this physical concept to high-refractive index material systems by the inclusion of low-refractive index layers, in hope for the reduction of SPP loss modes. However, the promised free-space light extraction efficiencies are on the order of 80%, and the choice of materials and the applicability to other operational wavelengths are highly restricted.

Therefore, it is the object of the present invention to introduce an inventive physical approach that tackles TIR-light trapping and diverging emission in any refractive index material light emitting platform, in fulfillment of the four industrial criteria listed above. More in precise, the present invention targets applications such as: LEDs, lasers, SPSs, and biomedical sensing; at different operational wavelengths.

## Detailed description of the invention

Waveguides have long been known for guiding light along their axes. Here in the Transfer Waveguide (TRANSGUIDE) they are used differently; where light is transferred sideways between different waveguide potentials. This invention is named TRANSGUIDE.

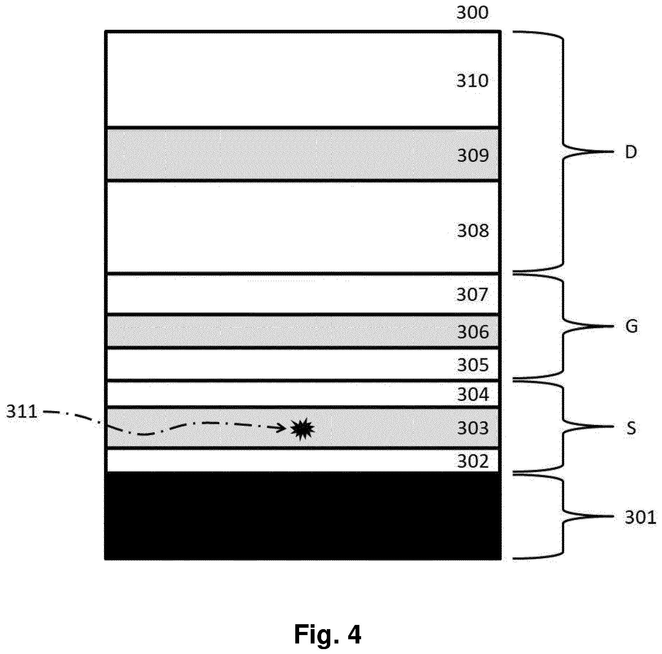

Fig. 4: A photon light emitter (311) is incubated in a waveguide named the source (S). The photon light emitter (311) can be one or more emitters. The designation "source" dates back to the waveguide's hosting for the photon light emitter (311). The source (S) comprises a core (303), a lower cladding (302), and an upper cladding (304); where ideally the photon light emitter (311) is located in the core (303). The source (S) functions in a similar manner to a dielectric waveguide, where the materials and the thicknesses of the source core (303), the source lower cladding (302), and the source upper cladding (304) are chosen such that the source (S) operates in leakage mode. In this context, leakage mode means that the light emitted by the photon light emitter (311) is minimally guided in the direction parallel to the source's core (303); instead, the light escapes from the source waveguide's sides, in the direction normal to the source's core (303). By placing a reflecting layer, named forward-bias (301), contiguous to the source's lower cladding (302), the part of the light that would escape from the source's bottom side will be directed upwards. In this arrangement, the source (S) cannot hold on to the light emitted by the photon light emitter (311), and the light is allowed to escape only from the source's upper cladding (304). The source (S) is a passive element, and does not change the wavelength of the light emitted by the photon light emitter (311). However, the photon light emitter (311) can be passive or active, and can be optically or electrically excited. The main functionality of the source (S) is to deplete the photon light emitter (311).

Fig. 4: Now that the photons emitted from the photon light emitter (311) can only leave the source (S) from its top side, the source upper cladding (304); an exit terminal is required to control the light's path. The gate (G) is also a waveguide, and is placed in the light's exit path. Ideally, the gate (G) functions in a similar manner to an antisymmetric Insulator Metal Insulator (IMI) waveguide; with (305) serving as the gate's lower cladding, (306) as the gate's core, and (307) as the gate's upper cladding, respectively. The gate (G) is positioned such that its lower cladding (305) is contiguous to the source's upper cladding (304). The materials and the thicknesses of gate's lower cladding (305), the gate's core (306), and the gate's upper cladding (307) are chosen such that the gate (G) operates in turn-off mode. In this context, turn-off mode means that the gate (G) is transparent with respect to the light emitted by the photon light emitter (311); i.e. supports a minimal guided mode in the direction parallel to the gate's core (306), and gives rise to minimal absorption. This configuration implies that, the light emitted by the photon light emitter (311) traverses the gate (G) in the direction perpendicular to the gate's core (306). The gate (G) is a passive element, and does not change the wavelength of the light emitted by the photon light emitter (311). The main functionality of the gate (G) is to serve as a valve for controlling the light flow out of the source (S). Conductor materials can also be used for the gate's lower cladding (305) and the gate's upper cladding (307).

Fig. 4: The light that exits the source (S) via the gate (G) is dumped into a third waveguide, called the drain (D), located directly on the other side of the gate (G). The drain (D) is comprised of a core (309), a lower cladding (308), and an upper cladding (310); and is placed such that its lower cladding (308) is contiguous to the gate's upper cladding (307). The drain (D) functions in a similar manner to a dielectric waveguide; where the materials and the thicknesses of drain's lower cladding (308), the drain's core (309), and the drain's upper cladding (310) are chosen such that the drain (D) operates in leakage mode. In this context, leakage mode means that the light emitted by the photon light emitter (311) is minimally guided in the direction parallel to the drain's core (309); instead, the light is allowed to escape from the drain waveguide's sides, in the direction normal to the drain's core (309). The light flow out of the source (S) is stored in the drain (D), in principle, in the drain's lower cladding (308) and in the drain's upper cladding (310). This light buildup in the drain's lower cladding (308) and in the drain's upper cladding (310) eventually bursts, i.e. is released, into the collection medium (300) contiguous to the drain's upper cladding (310). The drain (D) is also a passive element, and does not change the wavelength of the light emitted by the photon light emitter (311). The main functionality of the drain (D) is to create a temporarily light buildup, and follow it with an immediate burst.

Fig. 4: Overall, the three waveguides are configured not to trap the light emitted by the photon light emitter (311); instead, they pass the light on from their sides to the successive stage. The source (S) is coupled to the gate (G), the gate (G) is coupled to the drain (D), and the drain (D) is coupled to the collection medium (300). The forward-bias (301) ensures a flow of light along the channel, i.e. from the source (S) to the drain (D). Typically, a metallic mirror or a dielectric Bragg mirror would be an option for the forward-bias (301).

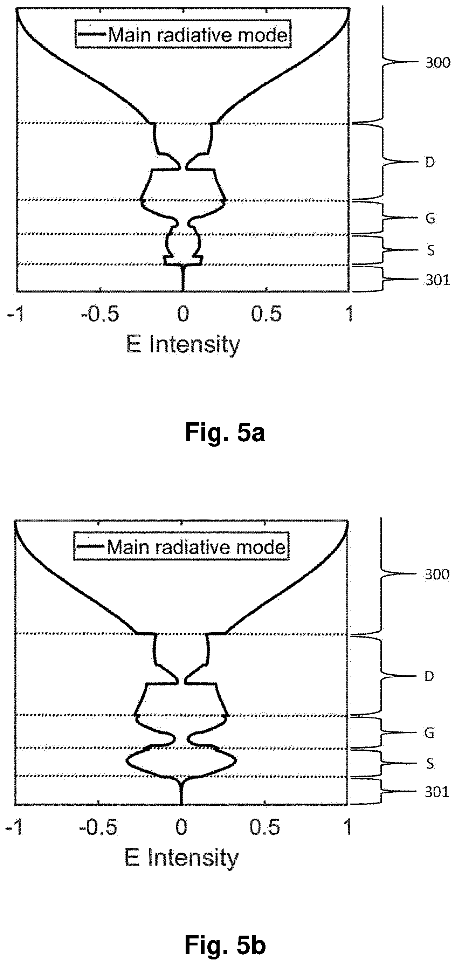

Fig. 5: While the light emitted by the photon light emitter flows from: the source (S), through the gate (G), to the drain (D), ending up in collection medium (300); it is crucial to pinch the light's path along the tunnel. In this context, a pinch means that the electric field intensity is decreased, i.e. approaches zero inside the waveguide core region. Fig. 5a shows an example of a TRANSGUIDE configuration that features -90% free-space light extraction efficiency. The main radiative mode is plotted in a cross-sectional view of the structure. One can see that the light is pinched three times before it is radiated into the free-space collection medium (300). The first pinch takes place in the source's core, followed by the second pinch in the gate's core, with the third pinch in the drain's core. In Fig. 5b, another example of a TRANSGUIDE configuration is shown; however, this configuration features -80% free-space light extraction efficiency. The inferior free-space light extraction efficiency, as compared to the configuration of Fig. 5a, is understood from the less number of pinches. The radiated light is only pinched twice: the first pinch is in the gate's core, followed by the second pinch in the drain's core.

In contrary to the previous discussed prior arts:

- The TRANSGUIDE does not rely on dipole-imaging nor interference effects; and therefore, there are no restrictions on the photon light emitter's position.
- The TRANSGUIDE does not rely on the suppression of SPP losses by the inclusion of low-refractive index materials at the metal-dielectric interfaces; and therefore, high-refractive index materials can be used anywhere without any restrictions.

**Invention design considerations**

There are many ways to put the source (S) and the drain (D) waveguides in leakage mode. There are also as many ways to put the gate (G) waveguide in turn-off mode. Here are some examples of possible options:

1. A metallic reflecting layer can serve as the forward-bias (301).
2. The source (S) can be a real-cladding waveguide. Meaning that, the refractive indices of the source's lower cladding (302) and the source's upper cladding (304) are different from the refractive index of the source's core (303); with the option that, the refractive indices of the source's lower cladding (302) and the source's upper cladding (304) are the same or different. In this context, real-cladding refers to the fact that a real physical interface exists between the core and the cladding since their materials are different.

3. The source (S) can be an imaginary-cladding waveguide. Meaning that, the refractive indices of the source's lower cladding (302) and the source's upper cladding (304) are the same as the refractive index of the source's core (303). In this context, imaginary-cladding refers to the fact that no real physical interface exists between the core and the cladding since their materials are the same. The physical interface in this case is an imaginary design parameter.

4. The gate (G) can be trenched. Meaning that, the refractive index of the gate's lower cladding (305) is different from the refractive index of the source's upper cladding (304). This implies that a real physical interface exists between the source (S) and the gate (G), i.e. between their contiguous claddings. This condition is applicable to the real-cladding source configuration (point 2) and to the imaginary-cladding source configuration (point 3).

5. The gate (G) can be merged. Meaning that, the refractive index of the gate's lower cladding (305) is the same as the refractive index of the source's upper cladding (304). This implies that no real physical interface exists between the source (S) and the gate (G), i.e. between their contiguous claddings. The physical interface in this case is an imaginary design parameter. This condition is applicable to the real-cladding source configuration (point 2) and to the imaginary-cladding source configuration (point 3).

6. The refractive indices of the drain's lower cladding (308) and the gate's upper cladding (307) can be the same or different; i.e. the physical interface between the gate (G) and the drain (D), between their contiguous claddings, can be real or imaginary. This condition can apply to any of the previous configurations.

7. For free-space emission applications the collection medium (300) is considered to be air. However; for non free-space emission applications, i.e. emission through a medium, the refractive index of the collection medium (300) can be equal to or different from the refractive index of the drain's upper cladding (310). This condition can apply to any of the previous configurations.

8. Any of the waveguide cores or claddings can be a single layer or multilayered. In the case of a multilayer, one has to consider the effective refractive index instead.

9. The photon light emitter (311) can be anywhere within the source's core (303).

## Invention advantages and comparisons with the prior art

This section presents selective TRANSGUIDE examples, with emphasis on highlighting the potentials of the invention and how it can confidently outperform any prior art. Performance comparisons are drawn based on a Silicon Vacancy (SiV) color center photon light emitter in a diamond active medium, at a 738 nm operational wavelength.

The theoretical results to be shown, whether for the TRANSGUIDE or those cited from the prior art, are all based on the same computational approach described in [4] and [5]. The approach has been experimentally verified in [1] and [3].

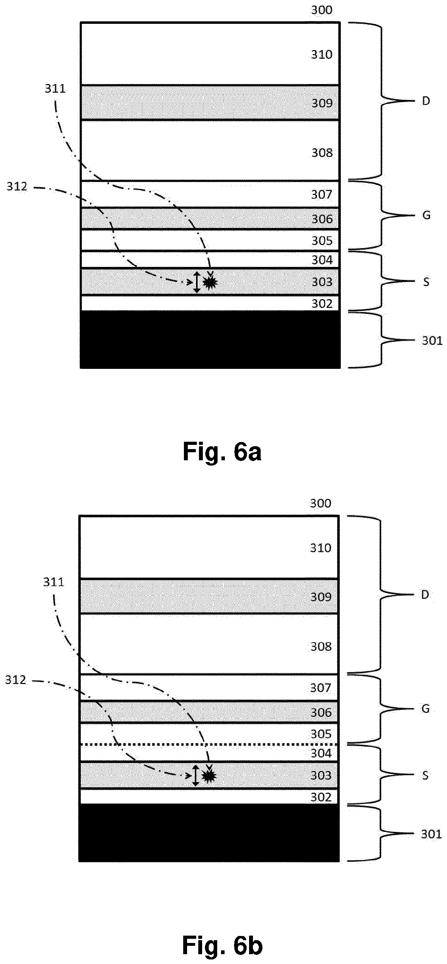

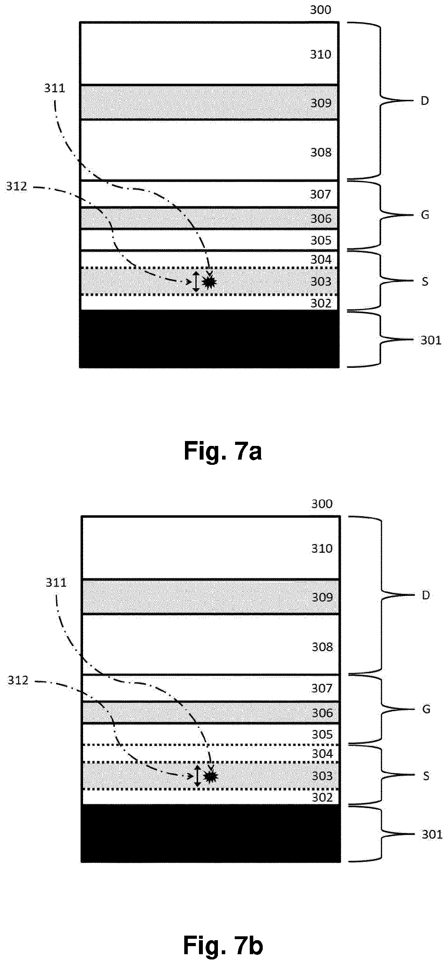

Fig. 6, Fig. 7: The photon light emitter (311) is considered initially in the center of the source's core (303). The photon light emitter position displacement $\Delta d$ (312), with respect to the initial position, is considered along the axis indicated by the double-headed arrow. Positive $\Delta d$ values correspond to moving towards the gate (G), while negative $\Delta d$ values correspond to moving towards the forward-bias (301). Solid horizontal lines represent real physical interfaces, while dotted horizontal lines represent imaginary physical interfaces.

Fig. 6a: This configuration is a real-cladding source featuring a trenched-gate. The refractive indices of the source's lower cladding (302) and the source's upper cladding (304) are the same and are smaller than the refractive index of the source's core (303). This implies that a real physical interface exists between the source's core and cladding. The refractive index of the gate's lower cladding (305) is larger than the refractive index of the source's upper cladding (304). This implies that a real physical interface exists between the gate and the source contiguous claddings. The configuration's design parameters are listed in Table 1. An important aspect of this configuration is that; the interface between the gate's core (306) and the gate's lower cladding (305) is a silver-sapphire interface, respectively.

Fig. 6b: This configuration is a real-cladding source featuring a merged-gate. The refractive indices of the source's lower cladding (302) and the source's upper cladding (304) are the same and are smaller than the refractive index of the source's core (303). This implies that a real physical interface exists between the source's core and cladding. The refractive index of the gate's lower cladding (305) is the same as the refractive index of the source's upper cladding (304). This implies that an imaginary physical interface exists between the gate and the source contiguous claddings. The configuration's design parameters are listed in Table 1. An important aspect of this configuration is that; the interface between the Gate's core (306) and the Gate's lower cladding (305) is a silver-silica interface, respectively.

Fig. 7a: This configuration is an imaginary-cladding source featuring a trenched-gate. The refractive indices of the source's lower cladding (302) and the source's upper cladding (304) are the same as the refractive index of the source's core (303). This implies that an imaginary physical interface exists between the source's core and cladding. The refractive index of the gate's lower cladding (305) is smaller than the refractive index of the source's upper cladding (304). This implies that a real physical interface exists between the gate and the source contiguous claddings. The configuration's design parameters are listed in Table 1. An important aspect of this configuration is that; the interface between the gate's core (306) and the gate's lower cladding (305) is a silver-ZnO interface, respectively.

Fig. 7b: This configuration is an imaginary-cladding source featuring a merged-gate. The refractive indices of the source's lower cladding (302) and the source's upper cladding (304) are the same as the refractive index of the source's core (303). This implies that an imaginary physical interface exists between the source's core and cladding. The refractive index of the gate's lower cladding (305) is the same as the refractive index of the source's upper cladding (304). This implies that an imaginary physical interface exists between the gate and the source contiguous claddings. The configuration's design parameters are listed in Table 1. An important aspect of this configuration is that; the interface between the gate's core (306) and the gate's lower cladding (305) is a silver-diamond interface, respectively.

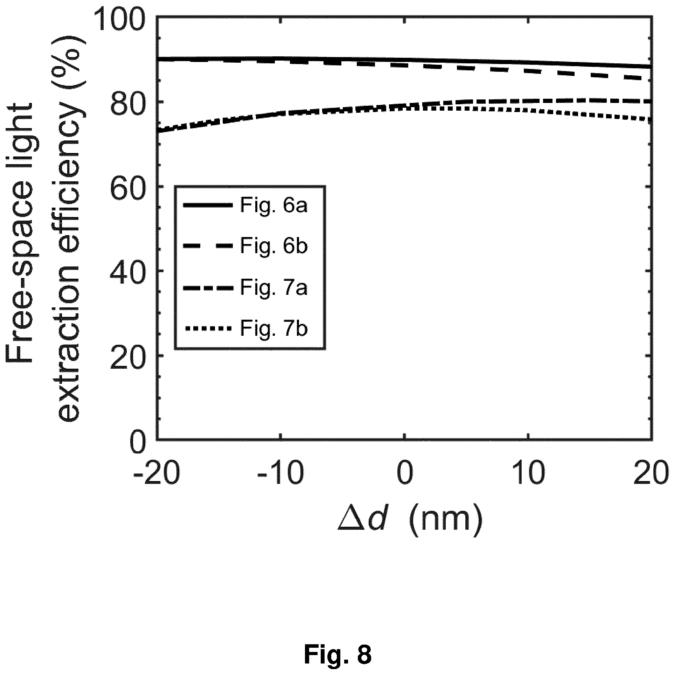

Fig. 8: This plot is a comparison based on the free-space light extraction efficiency, as a function of the photon light emitter displacement $\Delta d$ (312), drawn between the configurations in Fig. 6a, Fig. 6b, Fig. 7a, and Fig. 7b. For the four examples, the interface between the gate's core (306) and the gate's upper cladding (307) is a silver-TiO$_2$ interface respectively, while the interface between the gate's core (306) and the gate's lower cladding (305) is different. Refractive indices of TiO$_2$, diamond, ZnO, sapphire, and silica read: 2.54, 2.4, 1.96, 1.76, and 1.45 respectively.

Consider for now the configurations of Fig. 6a and Fig. 6b with their corresponding free-space light extraction efficiency plots in Fig. 8. One can see that, as the photon light emitter (311) approaches the gate (G), i.e. positive $\Delta d$ values, the free-space light extraction efficiency is higher when the refractive index of the gate's lower cladding (305) is larger. This behavior is in complete contradiction with the prior art WO002018096097 and [2]; where they report that the light extraction efficiency increases, provided that, the refractive index of the intermediate layer [Fig. 3c, layer (216)], interfaced with the metal director element [Fig. 3c, layer (209)], is reduced. It should also be noted that, the gate's core (306) from the other side has a very high-refractive index material upper cladding (307), $n_{TiO2}$ = 2.54. Following the same reasoning as in the prior art WO002018096097 and [2], the refractive index of the gate's upper cladding (307) should rather be small and on the order of 1.

| # | Fig. 6a | | Fig. 6b | | Fig. 7a | | Fig. 7b | |
|---|---|---|---|---|---|---|---|---|
| | Material | Thickness | Material | Thickness | Material | Thickness | Material | Thickness |
| (300) | Air | Semi-infinite | Air | Semi-infinite | Air | Semi-infinite | Air | Semi-infinite |
| (301) | Silver | 100 nm | Silver | 100 nm | Silver | 100 nm | Silver | 100 nm |
| (302) | Silica | 30 nm | Silica | 30 nm | Diamond | 25 nm | Diamond | 25 nm |
| (303) | Diamond | 50 nm | Diamond | 50 nm | Diamond | 50 nm | Diamond | 50 nm |
| (304) | Silica | 30 nm | Silica | 30 nm | Diamond | 25 nm | Diamond | 25 nm |
| (305) | Sapphire | 29 nm | Silica | 31 nm | ZnO | 12 nm | Diamond | 10 nm |
| (306) | Silver | 35 nm | Silver | 35 nm | Silver | 45 nm | Silver | 45 nm |
| (307) | TiO$_2$ | 62 nm | TiO$_2$ | 62 nm | TiO$_2$ | 62 nm | TiO$_2$ | 58 nm |
| (308) | Silica | 112 nm | Silica | 112 nm | Silica | 112 nm | Silica | 112 nm |
| (309) | TiO$_2$ | 58 nm | TiO$_2$ | 58 nm | TiO$_2$ | 68 nm | TiO$_2$ | 58 nm |
| (310) | Silica | 112 nm | Silica | 112 nm | Silica | 112 nm | Silica | 112 nm |

**Table 1**

For the configurations of Fig. 7a and Fig. 7b with their corresponding free-space light extraction efficiency plots in Fig. 8; a similar behavior can be remarked, where the free-space light extraction efficiency is higher for the trenched configuration of Fig. 7a. However, one might argue that the free-space light extraction efficiency increases because the gate-trenching in that case is equivalent to lowering the refractive index of the gate's lower cladding (305), which in turn reduces the coupling to SPP losses. This reasoning is completely wrong; because, if the refractive index of the gate's lower cladding (305) is even further lowered, for example gate-trenching with silica, the free-space light extraction efficiency decreases instead of increasing. The refractive index of the gate's lower cladding (305) in itself is not important, what matters is the leakage/turn-off and pinching of the waveguides.

The free-space light extraction efficiencies, shown in Fig. 8, for the configurations in Fig. 7a and Fig. 7b are inferior to those for the configurations of Fig. 6a and Fig. 6b. This is because; grouping the layers together by using a common material compromises the source's leakage operational mode. With reference to Fig. 5b (corresponds to the structure of Fig. 7a), a weak guided mode builds up within the grouped layers (302), (303), and (304). Furthermore, the radiative mode experiences pinches only in the core of the gate and in the core of the drain; lacking a pinch in the source's core (compare with Fig. 5a, corresponding to the structure of Fig. 6a). In spite of that, the free-space light extraction efficiency is more than 80%, which is already much higher than what the prior art WO2016166130 can deliver, and comparable to the prior art WO002018096097. However, layer grouping is a very practical feature. With the current state of the art nanofabrication, realization of very thin active medium layers can be very challenging for some materials. Thickening the active medium by grouping it with adjacent layers can be a solution.

To summarize, a free-space light extraction efficiency on the order of 90-100% in conjunction with a highly directional single-lobe radiation pattern has never been reported before in any prior art. Table 2 summarizes the relevant efforts in this regard.

| | Reference | Corresponding patent application | Free-space light extraction efficiency | Radiation pattern Half-Angle (HA) at full width half maximum |
|---|---|---|---|---|
| Prior art | [1], [2] Fig. 2a | WO2016166130 | ~40% | Single-lobe pattern, ~29° HA |
| | [2] Fig. 2b | WO002018096097 | ~80% | Single-lobe pattern, ~19° HA |
| | [2], [3] Fig. 1c | WO002018096097 | ~12% | Single-lobe pattern, ~8° HA |
| | [2], [3] Fig. 1d | WO002018096097 | ~54% | Single-lobe pattern, ~15° HA |
| TRANSGUIDE | Fig. 6a | Present invention | ~90% | Single-lobe pattern, ~19° HA |
| | Fig. 6b | Present invention | ~90% | Single-lobe pattern, ~19° HA |
| | Fig. 7a | Present invention | ~78% | Single-lobe pattern, ~27° HA |
| | Fig. 7b | Present invention | ~80% | Single-lobe pattern, ~24° HA |

**Table 2**

The TRANSGUIDE examples given throughout the context of this text are solely for demonstrating the potentials of the invention, and should not be considered limiting. Further enhancements are foreseen with selective choices of the materials and the design.

In all previous examples the collection medium (300) was considered free-space, i.e. air. The TRANSGUIDE is also compatible with emission through a medium, and in the case that the refractive index of the collection medium (300) is equal to or larger than the refractive index of the drain's upper cladding (310), the light extraction efficiency adds 2-5% more.

Another aspect, in all previous TRANSGUIDE examples the active medium was a high-refractive index material. This doesn't mean that the TRANSGUIDE is only applicable to high-refractive index light emitting platforms. In fact, the light extraction efficiency can be as high in low-refractive index material based applications; such as, biosensing and Organic Light Emitting Diodes (OLEDs). The next example demonstrates how the TRANSGUIDE can outperform the prior art even when it comes to low-refractive index active mediums.

**Low-refractive index platforms: TRANSGUIDE vs prior art**

Consider the anthracene-dibenzoterrylene (Ac-DBT) molecules system reported in the prior art WO2016166130 and [1], where the inventors-authors introduce an optimal design for their claimed planar antenna structure. However; the theoretical free-space light extraction efficiency for their system is no more than 60%. This shouldn't come as a surprise, since we are already aware that this prior art is struggling with SPP losses.

By applying the TRANSGUIDE to the said Ac-DBT molecules emitting at 785 nm, see design parameters in Table 3, the free-space light extraction efficiency can be as high as 93%, with the radiated light funneled into a single-lobe radiation pattern having a 19° HA. Reminding that, these results are also theoretical values, and have been obtained using the same computational approach used in WO2016166130 and [1].

|  | With reference to Fig. 4 | |
| --- | --- | --- |
| # | Material | Thickness |
| (300) | Air | Semi-infinite |
| (301) | Silver | 100 nm |
| (302) | Silica | 78 nm |
| (303) | DBT-Ac | 50 nm |
| (304) | Silica | 78 nm |
| (305) | Sapphire | 17 nm |
| (306) | Silver | 30 nm |
| (307) | TiO$_2$ | 68 nm |
| (308) | Silica | 120 nm |
| (309) | TiO$_2$ | 63 nm |
| (310) | Silica | 120 nm |

**Table 3**

## Waveguide operational modes

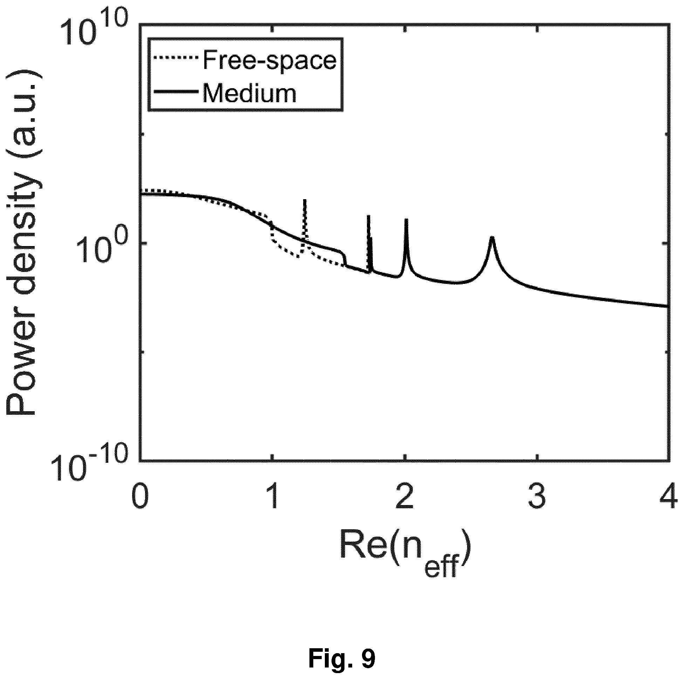

It has been demonstrated throughout the previous examples that, transferring light sideways between different waveguide potentials promises a 90-100% light extraction efficiency, provided that, the waveguides are configured in a certain way: the source (S) and the drain (D) waveguides should be operating in leakage mode; and the gate (G) waveguide should be operating in turn-off mode. These operational modes have already been defined in the previous sections; however, here in Fig. 9 they are illustrated to give more insight into the working principle of the TRANSGUIDE.

Fig. 9: For the configuration of Fig. 6a, the light emitted by the photon light emitter (311) is plotted as a function of the real-part of the effective refractive index; for two collection medium (300) cases: free-space and medium. Several peaks can be observed for each case; remarking that, the y-axis is on logarithmic scale since the contributions of the peaks between $Re(n_{eff}) = [1.5 : 3]$ are very weak that they are hardly visible on a linear scale. The peaks are explained as follows:

- The peak at $Re(n_{eff}) = 2.6$ represents the guided light in the source (S). Configuring the source (S) in leakage mode implies minimizing the amplitude of this peak, or even completely suppressing the peak.
- The peak at $Re(n_{eff}) = 1.9$ represents the guided light in the gate (G). Configuring the gate (G) in turn-off mode implies minimizing the amplitude of this peak, or even completely suppressing the peak.
- The peaks at $Re(n_{eff}) = 1.7$ and $Re(n_{eff}) = 1.2$ represent the guided light in the drain (D). Configuring the drain (D) in leakage mode implies minimizing the amplitudes of these peaks, or even completely suppressing the peaks.
- The continuum distribution towards the $Re(n_{eff}) = 0$ is more or less the light that is radiated into the collection medium (300).

The figure plots illustrate how the leakage of the drain (D) is enhanced when the collection medium (300) is changed from free-space to medium; where the peak at $Re(n_{eff}) = 1.2$ is completely suppressed and the other peak at $Re(n_{eff}) = 1.7$ is further minimized.

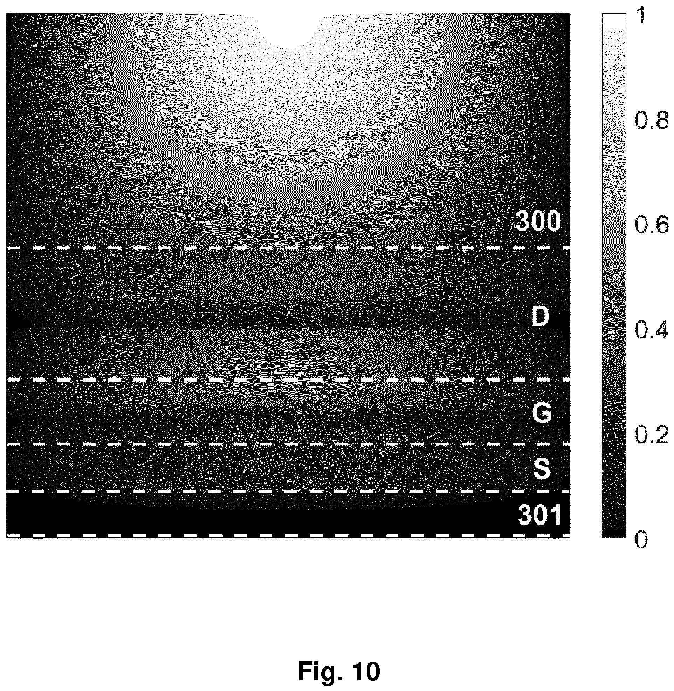

The eventual drain burst discussed earlier, is illustrated in Fig. 10, for the configuration of Fig. 6a. Along the extension direction of the collection medium (300), a very bright intensity light spot could be observed centered directly above the location of the photon light emitters in the source (S). It can also be seen that this bright spot is seeded from the buildup in the drain (D). Dashed lines mark the structure elements. The pinching is also apparent from the dark-black color mapping that the cores appear in.

**Conclusion**

Whether the light emitting platform is a low or high-refractive index material, irrespective of the operational wavelength, a 90-100% light extraction efficiency in conjunction with highly directional emission profiles are realizable in a complete flat ultra-thin architecture.

**Description of the figures**

Fig. 1: Cross-sectional view illustrating the technical background for the problem of total internal reflection light trapping and diverging emission.

Fig. 2: Cross-sectional views outlining the working principle of the prior art WO2016166130.

Fig. 3: Cross-sectional views outlining the working principle of the prior art WO002018096097.

Fig. 4: Cross-sectional view of the TRANSGUIDE.

Fig. 5: The main radiative mode plotted for two different TRANSGUIDE configurations: a) real-cladding source trenched-gate, configuration shown in Fig. 6a, design parameters listed in Table 1; b) imaginary-cladding source trenched-gate, configuration shown in Fig. 7a, design parameters listed in Table 1. The (S), (G), (D) waveguides, the forward-bias (301), and the collection medium (300) structures are overlaid on the plots. Interfaces between the listed structures are marked with dotted lines.

Fig. 6: Cross-sectional views: a) a TRANSGUIDE configuration featuring a real-cladding source trenched-gate; b) a TRANSGUIDE configuration featuring a real-cladding source merged-gate. Dotted lines represent an imaginary physical interface.

Fig. 7: Cross-sectional views: a) a TRANSGUIDE configuration featuring an imaginary-cladding source trenched-gate; b) a TRANSGUIDE configuration featuring an imaginary-cladding source merged-gate. Dotted lines represent an imaginary physical interface.

Fig. 8: Performance plots: the free-space light extraction efficiency as a function of the photon light emitter position displacement $\Delta d$ (312), for the configurations in Fig. 6 and Fig. 7.

Fig. 9: The light emitted by the dipole light emitter (311) as a function of the real-part of the effective refractive index, plotted for two collection medium (300) cases: free-space and medium. The two plots correspond to the configuration of Fig. 6a, but with the corresponding collection medium.

Fig. 10: The drain burst for the configuration of Fig. 6a plotted on a cross-sectional view of the structure, with the dashed lines marking the interfaces of the elements. The normalized color map bar gives an indication of the light intensity.

**Bibliography:**

[1] S. Checcucci, P. Lombardi, S. Rizvi, F. Sgrignuoli, N. Gruhler, F. B. C. Dieleman, F. S. Cataliotti, W. H. P. Pernice, M. Agio, and C. Toninelli, "Beaming light from a quantum emitter with a planar optical antenna," Light Sci. Appl. 6(4), e16245 (2016).

[2] H. Galal and M. Agio, "Highly efficient light extraction and directional emission from large refractive-index materials with a planar yagi-uda antenna," Opt. Mater. Express 7(5), 1634-1646 (2017).

[3] H Galal et al., "Highly efficient light extraction and directional emission from diamond color centers using planar Yagi-Uda antennas," arXiv preprint arXiv:1905.03363 (2019).

[4] K. A. Neyts, "Simulation of light emission from thin-film microcavities," J. Opt. Soc. Am. A 15(4), 962-971 (1998).

[5] X. W. Chen, W. C. Choy, and S. L. He, "Efficient and rigorous modeling of light emission in planar multilayer organic light-emitting diodes," J. Display. Technol. 3(2), 110-117 (2007).

**Claims**

1. Device for ultra-bright directional light emission, comprising:

   a forward-bias layer (301);
   a source waveguide (S), incubating one or more photon light emitters (311);
   a gate waveguide (G);
   a drain waveguide (D); and
   a collection medium (300),
   overlaid one upon another in this order

   wherein the forward bias layer (301) is a reflecting layer,
   wherein the source waveguide (S) functions in a similar manner to a dielectric waveguide and wherein the material, the thickness and the effective refractive index of each of the source lower cladding (302), the source core (303), and the source upper cladding (304) are configured such that the source waveguide (S) operates in leakage mode and is coupled to the gate waveguide (G), wherein leakage mode means that the light emitted by the photon light emitters (311) is minimally guided in the direction parallel to the source's core (303) and escapes from the source waveguide's sides in the direction normal to the source's core (303), wherein the gate waveguide (G) functions in a similar manner to an antisymmetric insulator-metal-insulator waveguide and wherein the material, the thickness and the effective refractive index of each of the gate lower cladding (305), the gate core (306), and the gate upper cladding (307) are configured such that the gate waveguide (G) operates in turn-off mode and is coupled to both the source waveguide (S) and the drain waveguide (D), wherein turn-off mode means that the gate (G) is transparent with respect to the light emitted by the photon light emitter (311); i.e. supports a minimal guided mode in the direction parallel to the gate's core (306), in which the light emitted by the photon light emitters (311) traverses the gate (G) in the direction perpendicular to the gate's core (306) and gives rise to minimal absorption, wherein the drain waveguide (D) functions in a similar manner to a dielectric waveguide, wherein the material, the thickness and the effective refractive index of each of the drain lower cladding (308), the drain core (309), and the drain upper cladding (310) are configured such that the drain waveguide (D) operates in leakage mode and is coupled to both the gate waveguide (G) and the collection medium (300), wherein leakage mode means that the light emitted by the photon light emitters (311) is minimally guided in the direction parallel to the drain's core (309) and escapes from the drain waveguide's sides in the direction normal to the drain's core (309), and wherein the source waveguide (S), the gate waveguide (G), and the drain waveguide (D) are passive and do not change the wavelength of the light emitted by the one or more photon light emitters (311); and wherein the photons emitted by the one or more photon light emitters (311) traverse the three said waveguides in the said order, along the direction normal to the three said waveguide cores.

2. Device according to claim 1,
   wherein the forward bias layer (301) is a metallic reflector, is a single layer or is multilayered, and has a reflectivity such that the photons emitted by the one or more photon light emitters (311) are transferred in order from the source waveguide (S), to the gate waveguide (G), to the drain waveguide (D), and finally to the collection medium (300).

3. Device according to claim 1,
   wherein the source lower cladding (302) is contiguous to the forward-bias (301).

4. Device according to any previous claim,
   wherein the one or more photon light emitters (311) are passive or active photon emitters, and can be located anywhere within the source core (303).

5. Device according to any previous claim,
wherein the gate lower cladding (305) is contiguous to the source upper cladding (304).

6. Device according to any previous claim,
wherein the drain lower cladding (308) is contiguous to the gate upper cladding (307), and the drain upper cladding (310) is contiguous to the collection medium (300).

7. Device according to any previous claim,
wherein the collection medium (300) extends in the direction away from the drain upper cladding (310).

8. Device according to any previous claim,
wherein any of the said waveguide cores or claddings, is a single layer or is multilayered.

9. Device according to claim 1,
wherein the effective refractive index of the drain upper cladding (310) is the same as or different from the refractive index of the collection medium (300).

10. Device according to one of the preceding claims,
wherein the collection medium (300) is free space with a refractive index equal tothe refractive index of air or is a medium with a refractive index larger than the refractive index of air.

11. Device according to any previous claim,
wherein the effective refractive indices of the source lower cladding (302) and of the source upper cladding (304) are the same as or different from the effective refractive index of the source core (303).

12. Device according to any previous claim,

wherein the effective refractive indices of the source upper cladding (302) and of the gate lower cladding (305) are the same or different or
the effective refractive indices of the gate upper cladding (307) and of the drain lower cladding (308) are the same or different.

**Patentansprüche**

1. Vorrichtung zur ultrahellen gerichteten Lichtemission, umfassend: eine Flussrichtungsschicht (301);

einen Source-Wellenleiter (S), der einen oder mehrere Photonenlichtemitter (311) enthält; einen Gate-Wellenleiter (G);
einen Drain-Wellenleiter (D); und
ein Sammelmedium (300),
die in dieser Reihenfolge übereinandergestapelt sind,

wobei die Flussrichtungsschicht (301) eine reflektierende Schicht ist,
wobei der Source-Wellenleiter (S) auf eine ähnliche Weise wie ein dielektrischer Wellenleiter funktioniert und wobei das Material, die Dicke und der effektive Brechungsindex von jedem des unteren Source-Mantels (302), des Source-Kerns (303) und des oberen Source-Mantels (304) so konfiguriert sind, dass der Source-Wellenleiter (S) im Leckmodus arbeitet und mit dem Gate-Wellenleiter (G) gekoppelt ist, wobei der Leckmodus bedeutet, dass das von den Photonenlichtemittern (311) emittierte Licht in der Richtung parallel zum Kern (303) der Source minimal geleitet wird und von den Seiten des Source-Wellenleiters in der Richtung senkrecht zum Kern (303) der Source entweicht,
wobei der Gate-Wellenleiter (G) auf eine ähnliche Weise wie ein antisymmetrischer Isolator-Metall-Isolator-Wellenleiter funktioniert und wobei das Material, die Dicke und der effektive Brechungsindex von jedem des unteren Gate-Mantels (305), des Gate-Kerns (306) und des oberen Gate-Mantels (307) so konfiguriert sind, dass der Gate-Wellenleiter (G) im Ausschaltmodus arbeitet und sowohl mit dem Source-Wellenleiter (S) als auch mit dem Drain-Wellenleiter (D) gekoppelt ist, wobei der Ausschaltmodus bedeutet, dass das Gate (G) in Bezug auf das von dem Photonenlichtemitter (311) emittierte Licht transparent ist; d. h. einen minimal geleiteten Modus in der Richtung parallel zum Kern (306) des Gates unterstützt, in dem das von den Photonenlichtemittern (311) emittierte Licht das Gate (G) in der Richtung senkrecht zum Kern (306) des Gates durchquert und zu einer minimalen Absorption führt,
wobei der Drain-Wellenleiter (D) auf eine ähnliche Weise wie ein dielektrischer Wellenleiter funktioniert, wobei das Material, die Dicke und der effektive Brechungsindex von jedem des unteren Drain-Mantels (308), des Drain-Kerns (309) und des oberen Drain-Mantels (310) so konfiguriert sind, dass der Drain-Wellenleiter (D) im Leckmodus arbeitet und sowohl mit dem Gate-Wellenleiter (G) als auch mit dem Sammelmedium (300) gekoppelt ist, wobei der Leckmodus bedeutet, dass das von den Photonenlichtemittern (311) emittierte Licht in der Richtung parallel zum Kern (309) des Drains minimal geleitet wird und von den Seiten des Drain-Wellenleiters in der Richtung senkrecht zum Kern (309) des Drains entweicht, und
wobei der Source-Wellenleiter (S), der Gate-Wellenleiter (G) und der Drain-Wellenleiter (D) passiv sind und die Wellenlänge des von dem einen oder den mehreren Photonenlichtemittern (311) emittierten Lichts nicht ändern; und wobei die von dem einen oder den mehreren Photonenlichtemittern (311) emittierten Photonen die drei Wellenleiter in der genannten Reihenfolge entlang der Richtung senkrecht zu den drei Wellenleiterkernen durchqueren.

2. Vorrichtung nach Anspruch 1,

wobei die Flussrichtungsschicht (301) ein metallischer Reflektor ist, eine einzelne Schicht ist oder mehrschichtig ist und ein Reflexionsvermögen aufweist, so dass die von dem einen oder den mehreren Photonenlichtemittern (311) emittierten Photonen in der Reihenfolge von dem Source-Wellenleiter (S) zu dem Gate-Wellenleiter (G),
zu dem Gate-Wellenleiter (G), zu dem Drain-Wellenleiter (D) und schließlich zu dem Sammelmedium (300) übertragen werden.

3. Vorrichtung nach Anspruch 1,
wobei der untere Source-Mantel (302) an die Flussrichtung (301) angrenzt.

4. Vorrichtung nach einem der vorhergehenden Ansprüche,

wobei der eine oder die mehreren Photonenlichtemitter (311) passive oder aktive Photonenlichtemitter sind, und irgendwo innerhalb des Source-Kerns (303) angeordnet sein können.

5. Vorrichtung nach einem der vorhergehenden Ansprüche,
wobei der untere Gate-Mantel (305) an den oberen Source-Mantel (304) angrenzt.

6. Vorrichtung nach einem der vorhergehenden Ansprüche,
wobei der untere Drain-Mantel (308) an den oberen Gate-Mantel (307) angrenzt und der obere Drain-Mantel (310) an das Sammelmedium (300) angrenzt.

7. Vorrichtung nach einem der vorhergehenden Ansprüche,
wobei sich das Sammelmedium (300) in der Richtung weg von dem oberen Drain-Mantel (307) erstreckt.

8. Vorrichtung nach einem der vorhergehenden Ansprüche,
wobei einer der Wellenleiterkerne oder -mäntel eine einzelne Schicht ist oder mehrschichtig ist.

9. Vorrichtung nach Anspruch 1,
wobei der effektive Brechungsindex des oberen Drain-Mantels (310) gleich dem oder verschieden von dem Brechungsindex des Sammelmediums (300) ist.

10. Vorrichtung nach einem der vorhergehenden Ansprüche,
wobei das Sammelmedium (300) ein freier Raum mit einem Brechungsindex gleich dem Brechungsindex von Luft ist oder ein Medium mit einem Brechungsindex größer als der Brechungsindex von Luft ist.

11. Vorrichtung nach einem der vorhergehenden Ansprüche,
wobei die effektiven Brechungsindizes des unteren Source-Mantels (302) und des oberen Source-Mantels (304) gleich dem oder verschieden von dem effektiven Brechungsindex des Source-Kerns (303) sind.

12. Vorrichtung nach einem der vorhergehenden Ansprüche,

wobei die effektiven Brechungsindizes des oberen Source-Mantels (302) und des unteren Gate-Mantels (305) gleich dem oder verschieden von den effektiven Brechungsindizes des oberen Gate-Mantels (307) und des unteren Drain-Mantels (308) sind.

## Revendications

1. Dispositif d'émission de lumière directionnelle ultra-lumineuse, comprenant :

   une couche de polarisation directe (301) ;
   un guide d'ondes de source (S), comprenant un ou plusieurs émetteurs de lumière photonique (311) ;
   un guide d'ondes de grille (G) ;
   un guide d'ondes de drain (D) ; et
   un milieu de collecte (300),
   superposés les uns sur les autres dans cet ordre

   dans lequel la couche de polarisation directe (301) est une couche réfléchissante,
   dans lequel le guide d'ondes de source (S) fonctionne d'une manière similaire à un guide d'ondes diélectrique et dans lequel le matériau, l'épaisseur et l'indice de réfraction effectif de chacun de l'habillage inférieur de source (302), du noyau de source (303) et de l'habillage supérieur de source (304) sont configurés de telle sorte que le guide d'ondes de source (S) fonctionne en mode de fuite et est couplé au guide d'ondes de grille (G), dans lequel le mode de fuite signifie que la lumière émise par les émetteurs de lumière photonique (311) est guidée de manière minimale dans la direction parallèle au noyau de source (303) et s'échappe des côtés du guide d'ondes de source dans la direction normale par rapport au noyau de source (303),
   dans lequel le guide d'ondes de grille (G) fonctionne d'une manière similaire à un guide d'ondes isolant-métal-isolant antisymétrique et dans lequel le matériau, l'épaisseur et l'indice de réfraction effectif de chacun de l'habillage inférieur de grille (305), du noyau de grille (306) et de l'habillage supérieur de grille (307) sont configurés de telle sorte que le guide d'ondes de grille (G) fonctionne en mode d'éteindre et est couplé à la fois au guide d'ondes de source (S) et au guide d'ondes de drain (D), dans lequel le mode d'éteindre signifie que la grille (G) est transparente par rapport à la lumière émise par l'émetteur de lumière photonique (311) ; c'est-à-dire qu'il supporte un mode minimal guidé dans la direction parallèle au noyau de grille (306), dans lequel la lumière émise par les émetteurs de lumière photonique (311) traverse la grille (G) dans la direction perpendiculaire au noyau de grille (306) et donne lieu à une absorption minimale,
   dans lequel le guide d'ondes de drain (D) fonctionne d'une manière similaire à un guide d'ondes diélectrique, dans lequel le matériau, l'épaisseur et l'indice de réfraction effectif de chacun de l'habillage inférieur de drain (308), du noyau de drain (309) et de l'habillage supérieur de drain (310) sont configurés de telle sorte que le guide d'ondes de drain (D) fonctionne en mode de fuite et est couplé à la fois au guide d'ondes de grille (G) et au milieu de collecte (300), dans lequel le mode de fuite signifie que la lumière émise par les émetteurs de lumière photonique (311) est guidée de manière minimale dans la direction parallèle au noyau de drain (309) et s'échappe des côtés du guide d'ondes de drain dans la direction normale par rapport au noyau de drain (309), et
   dans lequel le guide d'ondes de source (S), le guide d'ondes de grille (G) et le guide d'ondes de drain (D) sont passifs et ne changent pas la longueur d'onde de la lumière émise par l'un ou les plusieurs émetteurs de lumière photonique (311) ; et dans lequel les photons émis par l'un ou les plusieurs émetteurs de lumière photonique (311) traversent les trois dits guides d'ondes dans ledit ordre, le long de la direction normale par rapport aux trois dits noyaux de guide d'ondes.

2. Dispositif selon la revendication 1,
   dans lequel la couche de polarisation directe (301) est un réflecteur métallique, est une couche unique ou est multicouche, et a une réflectivité telle que les photons émis par l'un ou les plusieurs émetteurs de lumière photonique (311) sont transférés dans l'ordre du guide d'ondes de source (S), au guide d'ondes de grille (G), au guide d'ondes de drain (D), et finalement au milieu de collecte (300).

3. Dispositif selon la revendication 1,
   dans lequel l'habillage inférieure de source (302) est contigu à la polarisation directe (301).

4. Dispositif selon l'une quelconque des revendications précédentes,
   dans lequel l'un ou les plusieurs émetteurs de lumière photonique (311) sont des émetteurs de photons passifs ou actifs, et peuvent être situés n'importe où à l'intérieur du noyau de source (303).

5. Dispositif selon l'une quelconque des revendications précédentes,
dans lequel l'habillage inférieur de grille (305) est contigu à l'habillage supérieur de source (304).

6. Dispositif selon l'une quelconque des revendications précédentes,
dans lequel l'habillage inférieur de drain (308) est contigu à l'habillage supérieur de grille (307), et l'habillage supérieur de drain (310) est contigu au milieu de collecte (300).

7. Dispositif selon l'une quelconque des revendications précédentes,
dans lequel le milieu de collecte (300) s'étend dans la direction s'éloignant de l'habillage supérieur de drain (310).

8. Dispositif selon l'une quelconque des revendications précédentes,
dans lequel l'un quelconque desdits noyaux ou habillages de guide d'ondes est une couche unique ou est multicouche.

9. Dispositif selon la revendication 1,
dans lequel l'indice de réfraction effectif de l'habillage supérieur de drain (310) est identique à ou différent de l'indice de réfraction du milieu de collecte (300).

10. Dispositif selon l'une des revendications précédentes,
dans lequel le milieu de collecte (300) est un espace libre avec un indice de réfraction égal à l'indice de réfraction de l'air ou est un milieu avec un indice de réfraction supérieur à l'indice de réfraction de l'air.

11. Dispositif selon l'une quelconque des revendications précédentes,
dans lequel les indices de réfraction effectifs de l'habillage inférieur de source (302) et de l'habillage supérieur de source (304) sont identiques ou différents de l'indice de réfraction effectif du noyau de source (303).

12. Dispositif selon l'une quelconque des revendications précédentes,

dans lequel les indices de réfraction effectifs de l'habillage supérieur de source (302) et de l'habillage inférieur de grille (305) sont identiques ou différents ou
les indices de réfraction effectifs de l'habillage supérieur de grille (307) et de l'habillage inférieur de drain (308) sont identiques ou différents.

**Fig. 1**

Fig. 2a

Fig. 2b

Fig. 2c

**Fig. 3a**

**Fig. 3b**

**Fig. 3c**

**Fig. 4**

**Fig. 5a**

**Fig. 5b**

**Fig. 6a**

**Fig. 6b**

Fig. 7a

Fig. 7b

**Fig. 8**

**Fig. 9**

**Fig. 10**

## REFERENCES CITED IN THE DESCRIPTION

**Patent documents cited in the description**

- US 20110080738 A1
- US 20160079566 A1
- WO 2016166130 A

- WO 002018096097 A

**Non-patent literature cited in the description**

- **S. CHECCUCCI ; P. LOMBARDI ; S. RIZVI ; F. SGRIGNUOLI ; N. GRUHLER ; F. B. C. DIELEMAN ; F. S. CATALIOTTI ; W. H. P. PERNICE ; M. AGIO ; C. TONINELLI.** Beaming light from a quantum emitter with a planar optical antenna. *Light Sci. Appl.,* 2016, vol. 6 (4), e16245
- **H. GALAL ; M. AGIO.** Highly efficient light extraction and directional emission from large refractive-index materials with a planar yagi-uda antenna. *Opt. Mater. Express,* 2017, vol. 7 (5), 1634-1646

- **H GALAL et al.** Highly efficient light extraction and directional emission from diamond color centers using planar Yagi-Uda antennas. *arXiv preprint arXiv:1905.03363,* 2019
- **K. A. NEYTS.** Simulation of light emission from thin-film microcavities. *J. Opt. Soc. Am. A,* 1998, vol. 15 (4), 962-971
- **X. W. CHEN ; W. C. CHOY ; S. L. HE.** Efficient and rigorous modeling of light emission in planar multilayer organic light-emitting diodes. *J. Display. Technol.,* 2007, vol. 3 (2), 110-117